# EUROPEAN PATENT SPECIFICATION

(11) **EP 3 480 228 B1**
(45) Date of publication and mention of the grant of the patent: **16.06.2021**
(21) Application number: 17820335.2
(22) Date of filing: 30.06.2017
(51) Int. Cl.: C09J 175/16, H01L 21/683, C09J 11/06, C09J 11/08, C08F 290/06, C08G 18/75, C08G 18/67, C08G 18/44, C08G 18/48, C08G 18/76

(54) **COMPOSITION**
ZUSAMMENSETZUNG
COMPOSITION

(30) Priority: 01.07.2016 JP 2016131266
(43) Date of publication of application: 08.05.2019
(73) Proprietor: Denka Company Limited, Tokyo 103-8338 (JP)
(72) Inventor: SEKIYA,Ruriko, Machida-city Tokyo 194-8560 (JP); YAMASHITA,Yukihiko, Machida-city Tokyo 194-8560 (JP); WATANABE,Jun, Machida-city Tokyo 194-8560 (JP)
(74) Representative: Gulde & Partner
(86) International application number: PCT/JP2017/024201
(87) International publication number: WO 2018/003981

(56) References cited:
- WO-A1-2014/069266
- WO-A1-2015/037431
- JP-A- H08 301 953
- JP-A- 2006 117 826
- JP-A- 2006 117 826
- JP-A- 2007 262 175
- JP-A- 2007 314 715
- JP-A- 2011 140 568
- JP-A- 2011 140 568
- JP-A- 2011 153 187
- JP-A- 2014 130 853
- US-A1- 2010 012 263
- US-A1- 2012 246 913

## Description

### [Technical Field]

The present invention relates to a composition.

### [Background Art]

Three-dimensional semiconductor packaging is becoming indispensable for realizing even higher densities and larger capacities. Three-dimensional packaging technology is a semiconductor fabrication technology in which one semiconductor chip is thinned and then stacked in multiple layers. In order to realize this, a step is required for thinning the substrate on which the semiconductor circuit is formed by grinding a non-circuit forming surface (also referred to as a "back surface") and then forming electrodes on the back surface. Conventionally, in the step of grinding the back surface of a silicon substrate, a back surface protective tape is applied on the side opposite to the grinding surface to prevent damage to the wafer during grinding. However, although this tape uses an organic resin film as a base material and has flexibility, its strength and heat resistance are insufficient, and hence it is not suitable for performing the electrode forming step or the wiring layer forming step on the back surface.

Therefore, there has been proposed a system that can sufficiently withstand the steps of back surface grinding and back surface electrode formation by bonding the semiconductor substrate to a support such as silicon or glass via an adhesive. In this case, it is important for the adhesive layer to be provided when bonding the substrate to the support. This adhesive layer needs to have sufficient durability to bond the substrate to the support without gaps as well as to withstand the later steps, and also needs to be able to allow the thinned wafer to be easily peeled from the support at the end.

The necessary properties of the adhesive include a viscosity suitable for coating, a shear adhesive strength capable of withstanding grinding and polishing when thinning silicon, a heat resistance capable of withstanding an insulating film forming step and a solder reflow step, chemical resistance capable of withstanding thinning and a resist coating step, easy release properties that allow the wafer to be easily peeled from the support, easy washability, and the like.

As an adhesive and a method for peeling off the adhesive, there has been proposed a technique in which an adhesive layer is peeled from a support by irradiating high intensity light on an adhesive including a light-absorbing substance to decompose the adhesive layer (Patent Literature 1), and a technique in which bonding and peeling are carried out in a heated and melted state using a hot-melt hydrocarbon compound for the adhesive (Patent Literature 2). The former technique requires expensive apparatus such as a laser and has problems such as a long processing time per substrate. In addition, although the latter technique is simple because the technique is controlled by heating alone, on the other hand it has a narrow applicable technical range because thermal stability at high temperatures exceeding 200°C is insufficient.

There has also been disclosed a method of disassembling an adhered body in which at least one base material is transparent to excimer light, wherein the method includes a step of irradiating excimer light having the center wavelength of 172 nm or 193 nm on an adhered body formed by laminating base materials using an adhesive composition containing one or two or more (meth)acrylates having one or more (meth)acryloyl groups and curing the adhesive composition (Patent Literature 3). However, in the peeling method technique according to this prior art, there are problems in that it is necessary to use excimer light that has a high energy, and there is a high demand for equipment and the like in order to carry out the method.

An acrylic adhesive to which a fluorine compound is added has also been disclosed (Patent Literatures 4 and 5). However, Patent Literatures 4 and 5 do not describe a releasability imparting compound. In Patent Literatures 4 and 5, the fluorine compound is limited to a radical polymerizable monomer or oligomer, and there is no description of non-radical polymerizable fluorine compounds or (meth)acrylates having a specific molecular weight.

A photocurable resin composition containing one or more acrylic monomers, a polymerization initiator, and a fluorine surfactant and having a surface tension of 28 mN/m or less in the atmosphere has also been disclosed (Patent Literature 6). However, there is no description of molecular weight.

An adhesive composition including a reactive acrylic resin and a urethane resin as adhesive property components, in which the adhesive strength is reduced by heat treatment, has also been disclosed (Patent Literature 7). However, the thermal release method is based on organic thermally-expandable particles, and there is no description of using a photocurable resin.

A release material composition including an acrylic polymer containing a fluorine monomer as a constituent that is capable of easily controlling peeling force while suppressing heavy release has also been disclosed (Patent Literature 8). However, Patent Literature 8 does not describe the peeling force after heating.

JP 2007 262175 A discloses a composition comprising a monofunctional (meth)acrylate, a polyfunctional (meth)acrylate, a photopolymerization initiator, and a silicone compound composed of silicon and hydrolysable organic group. Upon immersion in warm water or an alcoholic solvent, the hydrolysable group is cleaved, so that the adherend and the resin composition are released.

US 2010/0012263 A discloses a curable composition comprising a monofunctional (meth)acrylate, a polyfunctional (meth)acrylate, a photopolymerization initiator, a polar solvent, and a granular material in form of spherical particles and insoluble in the composition. The granular material is used to ensure a constant thickness of the cured resin in order to improve machining accuracy of the adherend.

JP 2011 140568 A relates to a fiber coating material, comprising a silicone compound.

JP 2006 117826 A discloses a curable composition having good adhesion to inorganic materials. The composition comprises a silicone oil having a polymerizable group for improving wettability and adhesiveness with after curing.

US 2012/0246913 A discloses a curable composition comprising a monofunctional (meth)acrylate, a polyfunctional (meth)acrylate, a photopolymerization initiator, and a resin having a cyclopentadiene skeleton used to improve surface curing properties.

### [Citation List]

### [Patent Literature]

[Patent Literature 1] JP 2004-64040 A
[Patent Literature 2] JP 2006-328104 A
[Patent Literature 3] WO 2011/158654 A
[Patent Literature 4] JP 2014-130853 A
[Patent Literature 5] US 2013/0084459 A
[Patent Literature 6] JP 2015-54929 A
[Patent Literature 7] JP 2003-171648 A
[Patent Literature 8] JP 2016-79238 A

### [Summary of Invention]

### [Technical Problem]

The present invention has been completed as a result of various investigations into solving problems regarding, for example, heat resistance, adhesive properties, and release properties.

### [Solution to Problem]

Specifically, the present invention provides the following.
(1) A composition comprising the following components (A) to (E):
   component (A): a monofunctional (meth)acrylate having a number average molecular weight of less than 1000;
   component (B): a polyfunctional (meth)acrylate having a number average molecular weight of less than 1000;
   component (C): a radical polymerization initiator;
   component (D): a releasability imparting compound that is a liquid at an ordinary temperature (20±15°C) and is one or more selected from the group consisting of fluorine compounds and olefinic compounds; and
   component (E): a polyfunctional urethane (meth)acrylate.
(2) The composition according to (1), wherein the component (E) has a weight average molecular weight of 40000 or less.
(3) The composition according to (1) or (2), wherein the component (E) has a content of 35 to 90 parts by mass based on a total of components (A), (B), and (E) of 100 parts by mass, the component (D) has a content of 0.01 to 5 parts by mass based on a total of components (A), (B) and (E) of 100 parts by mass, and the component (C) has a content of 0.1 to 4 parts by mass based on a total of components (A), (B) and (E) of 100 parts by mass.
(4) The composition according to any one of (1) to (3), wherein the component (D) is a non-radical polymerizable compound.
(5) The composition according to any one of (1) to (4), wherein the component (D)further comprises a silicone compound.
(6) The composition according to (5), wherein the olefinic compound of component (D) is one or more selected from the group consisting of polyethylene polymers, polypropylene polymers, and ethylene/propylene copolymers.
(7) The composition according to any one of (1) to (6), wherein the component (A) is one or more selected from the group consisting of phenoxypolyalkylene glycol mono(meth)acrylates having an alkylene oxide chain, alkyl (meth)acrylates having a linear or branched chain alkyl group, monofunctional (meth)acrylates having an alicyclic alkyl group, and silicones having one (meth)acryloyl group, the component (B) is one or more selected from the group consisting of trimethylolpropane tri(meth)acrylate, ditrimethylolpropane tetra(meth)acrylate, tricyclodecane dimethanol di(meth)acrylate, dipentaerythritol hexa(meth)acrylate, pentaerythritol tetra(meth)acrylate, and pentaerythritol tri(meth) acrylate, the component (C) is a photo-radical polymerization initiator.
(8) A resin composition for semiconductor fabrication formed from the composition according to any one of (1) to (7).
(9) An adhesive formed from the composition according to any one of (1) to (7).
(10) A cured body obtained by curing the composition according to any one of (1) to (7).
(11) A temporary fixing adhesive for semiconductor fabrication formed from the composition according to any one of (1) to (7).
(12) An adhered body in which a base material is adhered with the temporary fixing adhesive for semiconductor fabrication according to (11).
(13) A method of fabricating a thinned wafer using the temporary fixing adhesive for semiconductor fabrication according to (11).

### [Advantageous Effects of Invention]

The present invention has, for example, heat resistance, adhesive properties, and release properties.

### [Description of Embodiments]

In this specification, unless stated otherwise, numerical ranges include the upper and lower limit values.

The present invention will now be described. The term polyfunctional (meth)acrylate refers to a compound having two or more (meth)acryloyl groups. The term monofunctional (meth)acrylate refers to a compound having one (meth)acryloyl group.

The monofunctional (meth)acrylate (A) has the number average molecular weight of less than 1000, preferably 900 or less, more preferably 800 or less, and most preferably 700 or less. The monofunctional (meth)acrylate may preferably be a monomer.

The weight average molecular weight and the number average molecular weight are calculated using a GPC system or the like to prepare a calibration curve based on commercially available standard polystyrene under the following conditions using tetrahydrofuran as a solvent.
Flow rate: 1.0 ml/min
Setting temperature: 40°C
Column configuration: One "TSK guardcolumn MP (×L)" 6.0 mm ID × 4.0 cm manufactured by Tosoh Corporation, two "TSK-GEL MULTIPOREHXL-M" 7.8 mm ID × 30.0 cm (theoretical plate number: 16,000) manufactured by Tosoh Corporation, for a total of three columns (total number of theoretical plates: 32,000), sample injection amount: 100 µl (sample solution concentration 1 mg/ml)
Feeding pressure: 39 kg/cm²
Detector: RI detector

The component (A) may preferably be one or more selected from: (A-1) phenoxypolyalkylene glycol mono(meth)acrylates having an alkylene oxide chain; (A-2) alkyl (meth)acrylates having a linear or branched alkyl group; (A-3) monofunctional (meth)acrylates having an alicyclic alkyl group; and (A-4) silicones having one (meth)acryloyl group.

The phenoxypolyalkylene glycol mono(meth)acrylate having an alkylene oxide chain (A-1) may preferably be a (meth)acrylate having the following formula (1). 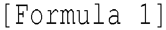 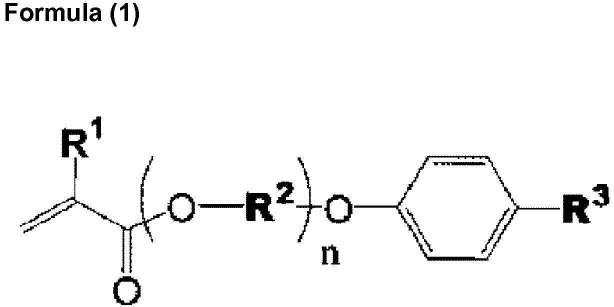
**(wherein R¹ and R³ are a hydrogen atom or an alkyl group,**
**R² is an alkylene group, and n is a positive number)**

R¹ may preferably be a hydrogen atom or a methyl group, and more preferably a hydrogen atom. R² may preferably be an alkylene group having 2 to 3 carbon atoms, and more preferably an ethylene group having 2 carbon atoms. R³ may preferably be a hydrogen atom or an alkyl group having 1 to 20 carbon atoms, more preferably an alkyl group having 1 to 20 carbon atoms, and most preferably a nonyl group having 9 carbon atoms. The number "n" may preferably be from 1 to 15, more preferably from 1 to 3, and most preferably 1. One or more of these (meth)acrylates may be used.

Examples of (meth)acrylates in which R³ is a nonyl group may include nonyl phenol ethylene oxide-modified (meth)acrylate, nonyl phenol (4 mol ethylene oxide-modified) (meth)acrylate, nonyl phenol (8 mol ethylene oxide-modified) (meth)acrylate, nonyl phenol (2.5 mol propylene oxide-modified) (meth)acrylate, and the like.

The alkyl (meth)acrylate having a linear or branched alkyl group (A-2) may preferably be a (meth)acrylate having the following formula (2).

Formula (2) CH₂=CR⁵-COO-R⁴ (R⁴ and R⁵ are an alkyl group.)
R⁴ may preferably be an alkyl group having 4 to 22 carbon atoms, more preferably an alkyl group having 8 to 20 carbon atoms, most preferably an alkyl group having 10 to 18 carbon atoms, still more preferably an alkyl group having 12 to 18 carbon atoms, and still even more preferably an alkyl group having 18 carbon atoms. One or more of these (meth)acrylates may be used. R⁵ may preferably be a hydrogen atom or a methyl group, and more preferably a hydrogen atom.

Examples of the alkyl (meth)acrylate having an alkyl group having 4 to 22 carbon atoms may include (meth)acrylates having a linear or branched alkyl group, such as hexyl (meth)acrylate, octyl (meth)acrylate, 2-ethylhexyl (meth)acrylate, nonyl (meth)acrylate, isononyl (meth)acrylate, decyl (meth)acrylate, isodecyl (meth)acrylate, stearyl (meth)acrylate, isostearyl (meth)acrylate, dodecyl (meth)acrylate, lauryl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicodecyl (meth)acrylate. Of these, lauryl (meth)acrylate, stearyl (meth)acrylate, and isostearyl (meth)acrylate are preferable, and isostearyl (meth)acrylate is most preferable.

Examples of the monofunctional (meth)acrylate having an alicyclic alkyl group (A-3) may include adamantyl (meth)acrylate, dicyclopentenyl (meth)acrylate, isobornyl (meth)acrylate, dicyclopentenyloxyethyl (meth)acrylate, cyclohexyl (meth)acrylate, and 1-(1-adamantyl)-1-methylethyl (meth)acrylate. Of these, from the viewpoint of heat resistance, 1-adamantyl (meth)acrylate is preferable.

The silicone having one (meth)acryloyl group (A-4) is a polyorganosiloxane having one (meth)acryloyl group in the molecule. The silicone to become the base polymer of the silicone may be a polysiloxane whose main chain has a siloxane bond. Examples of the silicone may include a dimethyl silicone in which all the side chains and the terminals are methyl groups, a methyl phenyl silicone including a phenyl group in a part of the side chains, a methyl hydrogen silicone in which a part of the side chains are hydrogen, and the like. Of these, a dimethyl silicone is preferable. The introduction position of the (meth)acryloyl group is not particularly limited, and may be at one terminal of the main chain (one-end type) or on a side chain (side-chain type). Among those, a polyorganosiloxane having a (meth)acryloyl group at one terminal is preferable.

The monofunctional (meth)acrylate (A) has a content of, based on the total of (A), (B), and (E) of 100 parts by mass, preferably 9 to 65 parts by mass, more preferably 9 to 60 parts by mass, even more preferably 13 to 50 parts by mass, and most preferably 16 to 45 parts by mass. When the content is 9 parts by mass or more, curing shrinkage is small. When the content is 65 parts by mass or less, there is no risk of heat resistance and release properties deteriorating.

The polyfunctional (meth)acrylate (B) has the number weight average of less than 1000, preferably 900 or less, more preferably 800 or less, and most preferably 700 or less. Examples of the polyfunctional (meth)acrylate (B) include bifunctional (meth)acrylates, trifunctional (meth)acrylates, and tetrafunctional or higher functional (meth)acrylates.

The polyfunctional (meth)acrylate (B) may preferably exclude the polyfunctional urethane (meth)acrylate of component (E).

Examples of bifunctional (meth)acrylates may include 1,3-adamantyldimethanol di(meth)acrylate, tricyclodecanedimethanol di(meth)acrylate, 1,3-butylene glycol di(meth)acrylate, 1,4-butanediol di(meth)acrylate, 1,6-hexadiol di(meth)acrylate, 1,9-nonanediol di(meth)acrylate, neopentyl glycol di(meth)acrylate, dicyclopentanyl di(meth)acrylate, neopentyl glycol-modified trimethylolpropane di(meth)acrylate, stearic acid-modified pentaerythritol di(meth)acrylate, tripropylene glycol di(meth)acrylate, 2,2-bis(4-(meth)acryloxydiethoxyphenyl)propane, 2,2-bis(4-(meth)acryloxypropoxyphenyl)propane, 2,2-bis(4-(meth)acryloxytetraethoxyphenyl)propane, dimethylol-tricyclodecane di(meth)acrylate, 1,10-decanediol di(meth)acrylate, isocyanuric acid ethylene oxide-modified di(meth)acrylate, and the like.

Examples of trifunctional (meth)acrylates may include isocyanuric acid ethylene oxide-modified tri(meth)acrylate, pentaerythritol tri(meth)acrylate, trimethylolpropane tri(meth)acrylate, tris[(meth)acryloyloxyethyl]isocyanurate, and the like.

Examples of tetrafunctional or higher functional (meth)acrylates may include ditrimethylolpropane tetra(meth)acrylate, dimethylolpropane tetra(meth)acrylate, pentaerythritol tetra(meth)acrylate, pentaerythritol ethoxytetra(meth)acrylate, dipentaerythritol penta(meth)acrylate, dipentaerythritol hexa(meth)acrylate, and the like.

Of these, it is preferable to select one or more from 1,3-adamantyldimethanol di(meth)acrylate, trimethylolpropane tri(meth)acrylate, isocyanuric acid ethylene oxide-modified di(meth)acrylate, isocyanuric acid ethylene oxide-modified tri(meth)acrylate, pentaerythritol tri(meth)acrylate, pentaerythritol tetra(meth)acrylate, ditrimethylolpropane tetra(meth)acrylate, dipentaerythritol penta(meth)acrylate, dipentaerythritol hexa(meth)acrylate, and tricyclodecanedimethanol di(meth)acrylate, more preferable to select one or more from trimethylolpropane tri(meth)acrylate, ditrimethylolpropane tetra(meth)acrylate, tricyclodecanedimethanol di(meth)acrylate, dipentaerythritol hexa(meth)acrylate, pentaerythritol tetra(meth)acrylate, and pentaerythritol tri(meth)acrylate, and most preferable to select one or more from trimethylolpropane tri(meth)acrylate, tricyclodecanedimethanol di(meth)acrylate, pentaerythritol tetra(meth)acrylate, and dipentaerythritol hexa(meth)acrylate.

The polyfunctional (meth)acrylate (B) has a content of, based on the total of (A), (B), and (E) of 100 parts by mass, preferably 1 to 30 parts by mass, more preferably 2 to 20 parts by mass, and most preferably 4 to 15 parts by mass. When the content is 1 part by mass or more, there is no risk of heat resistance deteriorating. When the content is 30 parts by mass or less, curing shrinkage is small.

The radical polymerization initiator (C) is preferably a photo-radical polymerization initiator. As the photo-radical polymerization initiator, from the viewpoint of heat resistance and low outgassing properties, it is preferable to select one or more from the group consisting of 2-hydroxy-1-{4-[4-(2-hydroxy-2-methyl-propionyl)-benzyl]-phenyl}-2-methyl-propan-1-one, 2-benzyl-2-dimethylamino-1-(4-morpholinophenyl)butanone-1,2-dimethylamino-2-(4-methyl-benzyl)-1-(4-morpholin-4-yl-phenyl)-butan-1-one, 2,2-dimethoxy-1,2-diphenylethan-1-one, bis(2,4,6-trimethylbenzoyl)phenylphosphine oxide, 2,4,6-trimethylbenzoyldiphenylphosphine oxide, oxy-phenyl-acetic acid 2-[2-oxo-2-phenyl-acetoxy-ethoxy]-ethyl ester, and oxy-phenyl-acetic acid 2-[2-hydroxy-ethoxy]-ethyl ester, more preferable to select one or more from 2-benzyl-2-dimethylamino-1-(4-morpholinophenyl)butanone-1,2-dimethylamino-2-(4-methylbenzyl)-1-(4-morpholin-4-yl-phenyl)-butan-1-one, 2,2-dimethoxy-1,2-diphenylethan-1-one, bis(2,4,6-trimethylbenzoyl)phenylphosphine oxide, 2,4,6-trimethylbenzoyldiphenylphosphine oxide, and 2,2-dimethoxy-1,2-diphenylethan-1-one, even more preferable to select one or more from 2-dimethylamino-2-(4-methylbenzyl)-1-(4-morpholin-4-yl-phenyl)-butan-1-one, 2,2-dimethoxy-1,2-diphenylethan-1-one, bis(2,4,6-trimethylbenzoyl)-phenylphosphine oxide, and 2,4,6-trimethylbenzoyl-diphenyl-phosphine oxide, and most preferable is 2,2-dimethoxy-1,2-diphenylethan-1-one.

The radical polymerization initiator (C) has the content of, from the viewpoint of curing properties, low outgassing properties, and heat resistance, based on the total of (A), (B), and (E) of 100 parts by mass, preferably 0.1 to 4 parts by mass, more preferably 0.5 to 4 parts by mass, and even more preferably 0.7 to 2.5 parts by mass. When the content of the radical polymerization initiator is 0.1 parts by mass or more, sufficient curing properties are obtained, and when the content is 4 parts by mass or less, low outgassing properties and heat resistance are excellent.

The term releasability imparting compound (D) refers to, for example, a compound imparting release properties. In the present invention, the component (D) is a liquid at ordinary temperature or a non-radical polymerizable compound. More preferably, the component (D) is a liquid at ordinary temperature and a non-radical polymerizable compound. Ordinary temperature is a temperature defined in JIS 8703: 1983, and refers to a range of 20 ±15°C. When the component (D) has a nature that allows it not to form uneven spots during spin coating (e.g., is a liquid at ordinary temperature, etc.), the transparency of the composition can be increased, UV curing can be carried out appropriately, and the surface smoothness when coating the composition can be increased. The releasability imparting compound (D) is one or more selected from fluorine compounds and olefinic compounds. According to an embodiment, the compound (D) is a combination of a fluorine compound and a silicone compound.

The fluorine compound (D-1) refers to a compound having fluorine. Examples of the fluorine compound may include fluorine surfactants, fluorine polymers, and the like. Of these, a fluorine surfactant is preferable. As the fluorine surfactant, a surfactant having a perfluoroalkyl group is preferable. The surfactant having a perfluoroalkyl group may preferably be one or more selected from fluorine oligomers having a perfluoroalkyl group (e.g., "F-553" manufactured by DIC Corporation), and non-radical polymerizable fluorine compounds having a perfluoroalkyl group (e.g., "FC-4430" and "FC-4432" manufactured by 3M Company, and "S-386" manufactured by AGC Seimi Chemical Co., Ltd.), and more preferably a non-radical polymerizable fluorine compound having a perfluoroalkyl group among non-radical polymerizable fluorine compounds having a perfluoroalkyl group, a perfluoroalkylsulfonic acid and/or salt thereof (e.g., "FC-4430" manufactured by 3M Company) is preferable.

The silicone compound (D-2), which is a non-radical polymerizable compound, is preferably a siloxane compound. The non-radical polymerizable compound may preferably be one or more selected from non-modified silicone oils (e.g., non-modified polydimethylsiloxanes such as "KF-96-100cs", "KF-96-1000cs", and "KF-96H-10000cs" manufactured by Shin-Etsu Chemical Co., Ltd.,), and non-reactive modified silicones modified with a non-radical polymerizable functional group (e.g., polyether-modified silicone oil "X-22-2516" (polyether, long chain alkyl, aralkyl-modified type) manufactured by Shin-Etsu Chemical Co., Ltd., fluoroalkyl-modified silicone oil "FL-100-1000cs" manufactured by Shin-Etsu Chemical Co., Ltd., and polyether-modified silicone oils "TSF4446", "TSF4460", "TSF4450", and "TSF4452" manufactured by Momentive Performance Materials Japan LLC), and is more preferably a non-reactive modified silicone modified with a non-radical polymerizable functional group. Among non-reactive modified silicones modified with a non-radical polymerizable functional group, it is preferable to select one or more from polyether-modified silicone oils. As the silicone compound, a compound having a viscosity of 20 to 20,000 mm²/s can be used.

The non-radical polymerizable olefinic compound (D-3) preferably has a number average molecular weight of 1000 to 10000. Among non-radical polymerizable olefinic compounds, one or more kinds selected from a polyethylene polymer, a polypropylene polymer, and an ethylene/propylene copolymer are preferable, and an ethylene/propylene copolymer is more preferable. Examples of ethylene/propylene copolymers include "LUCANT HC-600" (viscosity: 14,000 mPa·s) manufactured by Mitsui Chemicals, Inc., and "LUCANT HC-2000" (viscosity: 89,000 mPa·s) manufactured by Mitsui Chemicals, Inc. The viscosity of the ethylene/propylene copolymer is preferably 1,000 to 100,000 mPa·s.

The release-property imparting compound (D) preferably has the content of 0.01 to 5 parts by mass based on the total of (A), (B) and (E) of 100 parts by mass. For a fluorine compound, the content is more preferably 0.01 to 2 parts by mass, and most preferably 0.05 to 1 part by mass. For a silicone compound and an olefinic compound, the content is more preferably 0.05 to 3 parts by mass. When the content is 0.01 parts by mass or more, release properties are secured. When the content is 5 parts by mass or less, good adhesive properties are obtained and curing is ensured.

The polyfunctional urethane (meth)acrylate (E) (hereinafter sometimes referred to as "urethane (meth)acrylate") is a (meth)acrylate having a urethane bond. The component (E) preferably has the weight average molecular weight of 40000 or less, more preferably 300 or more and 40000 or less, most preferably 500 or more and 30000 or less, and still more preferably 1000 or more and 30000 or less. When the component (E) has the weight average molecular weight, it is possible to reduce or eliminate tack on the surface of the composition, to enhance the release properties of the composition, and to impart heat resistance to the composition.

The polyfunctional urethane (meth)acrylate (E) may preferably exclude polyfunctional (meth)acrylate of component (B). The polyfunctional urethane (meth)acrylate (E) is preferably a compound having two or more (meth)acryloyl groups and one or more urethane bonds in one molecule. The urethane (meth)acrylate may be obtained by, for example, reacting (e.g., polycondensating) a polyol compound (hereinafter represented by X), an organic polyisocyanate compound (hereinafter represented by Y), and a (meth)acrylate (hereinafter represented by Z), or reacting Y and Z. Here, the term (meth)acrylate includes (meth)acrylic acid. The urethane (meth)acrylate may be obtained by, for example, reacting the polyol compound (X) and the organic polyisocyanate compound (Y), and then introducing a (meth)acryloyl group into the remaining hydroxy group.

Methods for producing the urethane (meth)acrylate are described in, for example, Japanese Patent Laid-Open Nos. 7-25957, 2002-173515, 7-292048, and 2000-351819.

As the polyol compound, any polyhydric alcohol may be used. Examples thereof may include erythritol, polyether polyols, polyester polyols, polycarbonate polyols, ethylene glycol, propylene glycol, butylene glycol, 1,4-butanediol, 1,5-pentanediol, 1,6-hexanediol, 1,8-octanediol, 1,9-nonanediol, 3-methyl-1,5-pentanediol, 2,4-diethyl-1,5-pentanediol, 2,2-butylethyl-1,3-propanediol, neopentyl glycol, cyclohexane dimethanol, hydrogenated bisphenol A, polycaprolactone, trimethylolethane, trimethylolpropane, polytrimethylolpropane, polypentaerythritol, sorbitol, mannitol, glycerin, polyglycerin, polybutadiene polyols, hydrogenated polybutadiene polyols, and the like. The term polybutadiene polyol refers to a polybutadiene having two or more hydroxyl groups, for example, a polybutadiene having a hydroxyl group at either end. The term hydrogenated polybutadiene polyol refers to a hydrogenated polybutadiene having two or more hydroxyl groups, for example, a hydrogenated polybutadiene having a hydroxyl group at either end.

Examples of the polyether polyol may include polyalkylene glycols such as diethylene glycol, triethylene glycol, tetraethylene glycol, polyethylene glycol, dipropylene glycol, polypropylene glycol, polybutylene glycol, and polytetramethylene glycol, polyether polyols having at least one structure of block or random copolymerization of polyethylene oxide, polypropylene oxide, and ethylene oxide/propylene, and the like.

Examples of the polyester polyol may include a polyester polyol, which is a condensation product of a polyhydric alcohol or a polyether polyol and a polybasic acid. Examples of the polyhydric alcohol or polyether polyol used for producing the polyester polyol may include the above-mentioned compounds. Examples of the polybasic acid may include maleic anhydride, maleic acid, fumaric acid, itaconic anhydride, itaconic acid, adipic acid, isophthalic acid, and the like.

The organic polyisocyanate compound (Y) may include, but not limited to, aromatic, aliphatic, cycloaliphatic, and alicyclic polyisocyanates. Of these, polyisocyanates such as tolylene diisocyanate (TDI), diphenylmethane diisocyanate (MDI), hydrogenated diphenylmethane diisocyanate (H-MDI), polyphenylmethane polyisocyanate (crude MDI), modified diphenylmethane diisocyanate (modified MDI), hydrogenated xylylene diisocyanate (H-XDI), xylylene diisocyanate (XDI), hexamethylene diisocyanate (HMDI), trimethylhexamethylene diisocyanate (TMXDI), tetramethylxylylene diisocyanate (m-TMXDI), isophorone diisocyanate (IPDI), norbornene diisocyanate (NBDI), and 1,3-bis(isocyanatomethyl)cyclohexane (H6XDI), trimer compounds of these polyisocyanates, reaction products of these polyisocyanates with polyols, and the like can suitably be used. Among those, it is preferable to use one or more from the group consisting of tolylene diisocyanate (TDI), hydrogenated xylylene diisocyanate (H-XDI), and isophorone diisocyanate (IPDI), and more preferable to use isophorone diisocyanate.

The term (meth)acrylate (Z) refers to a compound that introduces a (meth)acryloyl group. Examples of the compound introducing a (meth)acryloyl group may include (meth)acrylic acid, (meth)acrylic acid chloride, hydroxy alkyl (meth)acrylates such as 2-hydroxyethyl (meth)acrylate, 2-hydroxypropyl (meth)acrylate, 2-hydroxybutyl (meth)acrylate, and 4-hydroxybutyl (meth)acrylate, 2- hydroxyethyl (meth)acryloyl phosphate, 4-butylhydroxy (meth)acrylate, 2-(meth)acryloyloxyethyl-2-hydroxypropyl phthalate, glycerin di(meth)acrylate, 2-hydroxy-3-(meth)acryloyloxypropyl (meth)acrylate, pentaerythritol tri(meth)acrylate, dipentaerythritol penta(meth)acrylate, caprolactone-modified 2-hydroxyethyl (meth)acrylate, and the like. Of these, one or more from the group consisting of (meth)acrylic acid, (meth)acrylic acid chloride, and hydroxyalkyl (meth)acrylates are preferable.

Examples of the urethane (meth)acrylate may include polyester urethane (meth)acrylates, polyether urethane (meth)acrylates, 1,2-polybutadiene-terminal urethane (meth)acrylates, and the like.

The polyester urethane (meth)acrylate has two or more (meth)acryloyl groups at the terminals or on side chains of the molecule, and has a polyester structure in the molecule. Examples of the polyester urethane (meth)acrylate include "UV-3000B" manufactured by The Nippon Synthetic Chemical Industry Co., Ltd., "UF-C02" manufactured by Kyoeisha Chemical Co., Ltd., and the like.

The polyether urethane (meth)acrylate has two or more (meth)acryloyl groups at the terminals or on side chains of the molecule, and has a polyether structure in the molecule. Examples of the compound having a polyether structure may include polyether polyol compounds. Examples of the polyether polyol compound include the above-mentioned polyether polyols and the like. Among polyether polyols, polyalkylene glycols are preferable. Among polyalkylene glycols, polypropylene glycol and tetramethylene glycol are preferable. Examples of the polyether urethane (meth)acrylate include "UV-3700B" manufactured by The Nippon Synthetic Chemical Industry Co., Ltd., "UN-6200" and "UN-6202" manufactured by Negami Chemical Industrial Co., Ltd., "UF-07DF" manufactured by Kyoeisha Chemical Co., and "UA-160TM" manufactured by Shin-Nakamura Chemical Co., Ltd., and the like.

Examples of 1,2-polybutadiene-terminal urethane (meth)acrylates may include urethane (meth)acrylates in which the polyol compound (X) is a polybutadiene polyol and the like. Examples of 1,2-polybutadiene-terminal urethane (meth)acrylates may include "TE-2000" manufactured by Nippon Soda Co., Ltd., and the like.

Examples of polyfunctional urethane (meth)acrylates may include bifunctional or higher polyfunctional urethane (meth)acrylates. Examples of polyfunctional urethane (meth)acrylates may include bifunctional urethane (meth)acrylates, trifunctional urethane (meth)acrylates, tetrafunctional urethane (meth)acrylates, hexafunctional or higher functional urethane (meth)acrylates, and the like. For example, polyfunctional urethane (meth)acrylate refers to a urethane (meth)acrylate having two or more (meth)acryl groups, bifunctional urethane (meth)acrylate refers to a urethane (meth)acrylate having two (meth)acryl groups, hexafunctional urethane (meth)acrylate refers to a urethane (meth)acrylate having six (meth)acryl groups, and decafunctional urethane (meth)acrylate refers to a urethane (meth)acrylate having ten (meth)acryl groups.

Among these, one or more selected from the group consisting of polyfunctional urethane (meth)acrylates having two to three functional groups and polyfunctional urethane (meth)acrylates having four and more functional groups are preferable, and a combination of a polyfunctional urethane (meth)acrylate having two or three functional groups and a polyfunctional urethane (meth)acrylate having four or more functional groups is more preferable. Among polyfunctional urethane (meth)acrylates having two to three functional groups, a polyfunctional urethane (meth)acrylate having two functional groups is more preferable. Among polyfunctional urethane (meth)acrylates having four and more functional groups, a polyfunctional urethane (meth)acrylate having six to ten functional groups is preferable, and one or more from the group consisting of polyfunctional urethane (meth)acrylates having six functional groups and polyfunctional urethane (meth)acrylates having ten functional groups are more preferable.

When a polyfunctional urethane (meth)acrylate having two to three functional groups and a polyfunctional urethane (meth)acrylate having four or more functional groups are used in combination, the content ratio is, in terms of the mass ratio of the polyfunctional urethane (meth)acrylate having two to three functional groups to the polyfunctional urethane (meth)acrylate having four or more functional groups, based on the total of the polyfunctional urethane (meth)acrylate having two to three functional groups and the polyfunctional urethane (meth)acrylate having four or more functional groups of 100 parts by mass, preferably 20 to 95:80 to 5, more preferably 50 to 90:50 to 10, and most preferably 65 to 85: 35 to 15.

Examples of the polyfunctional urethane (meth)acrylate may include bifunctional urethane (meth)acrylates (e.g., polyester urethane acrylate "UN-7700", polyether urethane acrylates "UN-6200" and "UN-6202", and polycarbonate urethane acrylates "UN-900PEP" and "UN-9200A" manufactured by Negami Chemical Industrial Co., Ltd., urethane acrylates "UF-07DF" and "UF-C012" manufactured by Kyoeisha Chemical Co., Ltd., and polyether urethane acrylate "UA-160TM" manufactured by Shin-Nakamura Chemical Co., Ltd.), hexafunctional urethane (meth)acrylates (e.g., urethane acrylate "UN-3320HA" manufactured by Negami Chemical Industrial Co., Ltd.), and decafunctional urethane (meth)acrylates (e.g., urethane acrylate "U-10PA" manufactured by Shin-Nakamura Chemical Co., Ltd.).

The polyfunctional urethane (meth)acrylate (E) has a content of, based on the total of (A), (B), and (E) of 100 parts by mass, preferably 35 to 90 parts by mass, more preferably 40 to 85 parts by mass, and even more preferably 45 to 80 parts by mass. When the content is 35 parts by mass or more, tackiness disappears. When the content is 90 parts by mass or less, there is no possibility of a deterioration in handleability due to the viscosity becoming too high.

The composition of the present invention may contain an antioxidant to maintain release properties after exposure to high temperatures. Examples of the antioxidant may include methyl hydroquinone, hydroquinone, 2,2-methylene-bis(4-methyl-6-tertiary butylphenol), catechol, hydroquinone monomethyl ether, monotertiary butyl hydroquinone, 2,5-ditertiary butyl hydroquinone, p-benzoquinone, 2,5-diphenyl-p-benzoquinone, 2,5-ditertiary butyl-p-benzoquinone, picric acid, citric acid, phenothiazine, tertiary butyl catechol, 2-butyl-4-hydroxyanisole, 2,6-ditertiarybutyl-p-cresol, 4-[[4,6-bis(octylthio)-1,3,5-triazin-2-yl]amino]-2,6-ditertiary butylphenol, and the like. Of these, 4-[[4,6-bis(octylthio)-1,3,5-triazin-2-yl]amino]-2,6-ditertiary butylphenol is preferable.

The antioxidant has the content of, based on the total of (A), (B), and (E) of 100 parts by mass, preferably 0.001 to 3 parts by mass. When the content is 0.001 parts by mass or more, maintenance of the release properties after exposure to high temperature is secured. When the content is 3 parts by mass or less, good adhesive properties are obtained and curing is ensured.

In order to ensure heat resistance, it is preferable that the composition of the present invention does not include components (thiol compounds or the like) that lead to a reduction in molecular weight.

The composition of the present invention may be used as an adhesive. The adhesive according to the present invention may be used as a temporary fixing adhesive.

When adhering base materials to each other using the composition according to the present invention, it is preferable to irradiate visible light or ultraviolet light at the wavelength of 365 nm so that the energy amount is in the range of 1 to 10000 mJ/cm². When the energy amount is 1 mJ/cm² or more, sufficient adhesive properties are obtained. When the energy amount is 10000 mJ/cm² or less, productivity is excellent, a decomposition product from the radical polymerization initiator (particularly, photo-radical polymerization initiator) is less likely to occur, and outgassing is also suppressed. From the viewpoint of productivity, adhesive properties, outgassing properties, and easy release properties, the energy amount is more preferably in the range of 2000 to 7000 mJ/cm².

At least one of the base materials to be adhered by the composition according to the present invention may include, but not limited to, a semiconductor. Examples of semiconductors may include silicon, germanium, gallium-arsenic, gallium-phosphorus, gallium-arsenic-aluminum, and the like. Among semiconductors, silicon is preferable. Wafers are preferable among semiconductors.

At least one of the base materials to be adhered by the composition according to the present invention may be, but not limited to, a transparent base material that allows light to pass through. Examples of transparent base materials may include inorganic base materials such as rock crystal, glass, quartz, and calcium fluoride, and organic base materials such as plastics. Of these, one or more selected from glass and quartz are preferable from the viewpoint of versatility and large effect.

In one embodiment, the composition according to the present invention is photocurable, and its cured body can have excellent heat resistance and release properties. In one embodiment, the cured body of the composition of the present invention provides a low outgas even when exposed to high temperature, and peeling is also easy, and hence the cured body is suitable for the bonding, sealing, and coating of various optical parts, optical devices, and electronic parts. For example, the cured body can be used as a temporary fixing agent, an adhesive, a protective sheet, a low birefringence optical film, an interlayer stress relaxation agent, and the like. In particular, the cured body is suited for applications requiring wide-ranging durability, such as solvent resistance, heat resistance, adhesive strength, and the like such as in semiconductor fabrication processes, SAW device working processes, and LED working processes.

From the viewpoint of heat resistance, the cured body of the composition according to the present invention may preferably be used at 350°C or less, more preferably 300°C or less, and most preferably 250°C or less. From the viewpoint of release properties, the cured body of the composition according to the present invention may preferably be used at 60°C or more, more preferably 100°C or more, and most preferably 150°C or more, and still more preferably 200°C or more. The adhered body adhered by the composition of the present invention has high shear adhesive strength, and hence it can withstand a thinning step and the like, and it can also be easily peeled off after being subjected to a heating step such as formation of an insulating film. The adhered body adhered by the present composition is particularly suitable for fabricating a thinned wafer.

Furthermore, in one embodiment of the present invention, peeling may be performed by applying an external force to the adhered body to which a base material is adhered by an adhesive. For example, the adhered body may be peeled off by inserting a sheet, a wire, a blade, and the like.

### [Examples]

The present invention is now described in more detail with reference to experimental examples, but the present invention is not limited thereto.

### (Experimental Examples)

Unless stated otherwise, the experiment examples were carried out at 23°C and 50% humidity. Curable resin compositions having the compositions shown in Tables 1 to 4 were prepared and evaluated.

The following compounds were selected as the respective components in the curable resin compositions described in the experimental examples.

The following compounds were selected as the monofunctional (meth)acrylate (A) having a number average molecular weight of less than 1000.
(A-1) Nonylphenol ethylene oxide-modified acrylate ("M-111" manufactured by Toagosei Co., Ltd. For its structure, in formula (1), R¹ is a hydrogen atom, R² is an ethylene group, R³ is a nonyl group, and n is 1)
(A-2) Isostearyl acrylate ("ISTA" manufactured by Osaka Organic Chemistry Industry Ltd.)
(A-3) 1-adamantyl methacrylate ("ADMA" manufactured by Osaka Organic Chemistry Industry Ltd.)

The following compounds were selected as the polyfunctional (meth)acrylate (B) having the number average molecular weight of less than 1000.
(B-1) Trimethylolpropane trimethacrylate ("TMPTM" manufactured by Shin-Nakamura Chemical Co., Ltd.)
(B-2) Tricyclodecane dimethanol diacrylate ("A-DCP" manufactured by Shin-Nakamura Chemical Co., Ltd.)
(B-3) Pentaerythritol tetra(meth)acrylate
(B-4) Dipentaerythritol hexa(meth)acrylate

The following compounds (photo-radical polymerization initiators) were selected as the radical polymerization initiator (C).
(C-1) 2,2-Dimethoxy-1,2-diphenylethan-1-one ("Irgacure651" manufactured by BASF Co., Ltd., hereinafter abbreviated as "1-651")
(C-2) 2-Dimethylamino-2-(4-methyl-benzyl)-1-(4-morpholin-4-yl-phenyl)-butan-1-one ("Irgacure379" manufactured by BASF Co., Ltd., hereinafter abbreviated as "1-379")
(C-3) Bis(2,4,6-trimethylbenzoyl)-phenylphosphine oxide ("Irgacure819" manufactured by BASF Co., Ltd., hereinafter abbreviated as "1-819")

The following compounds were selected as the releasability imparting compound (D).
(D-1) Perfluoroalkyl group-containing oligomer ("FC-4430" manufactured by 3M Company, a copolymer of 2-[N-perfluorobutylsulfonyl-N-methylamino]ethyl acrylate, poly(oxyalkyleneglycol) monoacrylate and poly(oxyalkyleneglycol) diacrylate)
(D-2) Fluorine-containing oligomer ("F-553" manufactured by DIC Corporation, including a perfluoroalkyl group)
(D-3) Long chain alkyl, aralkyl, polyether-modified organosiloxane ("X-22-2516" manufactured by Shin-Etsu Chemical Co., Ltd., viscosity: 70 mm²/s)
(D-4) Polyether-modified organosiloxane ("X-22-4515" manufactured by Shin-Etsu Chemical Co., Ltd., viscosity: 4,000 mm²/s)
(D-5) Polyether-modified organosiloxane (polyether-modified silicone oil "TSF4446" manufactured by Momentive Performance Materials Japan LLC, viscosity: 1,400 mm²/s)
(D-6) Ethylene/propylene copolymer ("LUCANT HC-600" manufactured by Mitsui Chemicals, Inc., viscosity: 14,000 mPa·s, number average molecular weight: 2700, hereinafter abbreviated as "HC-600")
(D-7) Ethylene/propylene copolymer ("LUCANT HC-2000" manufactured by Mitsui Chemicals, Inc., viscosity: 89,000 mPa·s, number average molecular weight: 7700, hereinafter abbreviated as "HC-2000")

The following compounds were selected as the polyfunctional urethane (meth)acrylate (E).
(E-1) Urethane acrylate A (Polyfunctional urethane acrylate, which is a condensation reaction product of a polyfunctional acrylate having a weight average molecular weight of 1500 and isocyanate. The polyfunctional acrylate is pentaerythritol triacrylate. The organic polyisocyanate compound is IPDI. Hexafunctional.)
(E-2) Urethane acrylate B (Polyfunctional urethane acrylate, which is a condensation reaction product of a polyfunctional acrylate having a weight average molecular weight of 1000 and isocyanate. The polyfunctional urethane acrylate is dipentaerythritol pentaacrylate. The organic polyisocyanate compound is IPDI. Decafunctional.)
(E-3) Urethane acrylate C (Polyether urethane acrylate having a weight average molecular weight of 6000. The polyol compound is polypropylene glycol. The organic polyisocyanate compound is IPDI. The acrylate is 2-hydroxyethyl acrylate. Bifunctional.)
(E-4) Urethane acrylate D (Polyether urethane acrylate having a weight average molecular weight of 11000. The polyol compound is polypropylene glycol. The organic polyisocyanate compound is IPDI. The acrylate is 2-hydroxyethyl acrylate. Bifunctional.)
(E-5) Urethane acrylate E (Polyether urethane acrylate having a weight average molecular weight of 5200. The polyol compound is tetramethylene glycol. The organic polyisocyanate compound is IPDI. The acrylate is 2-hydroxyethyl acrylate. Bifunctional.)
(E-6) Urethane acrylate F (Polyether urethane acrylate having a weight average molecular weight of 8500. The polyol compound is tetramethylene glycol. The organic polyisocyanate compound is IPDI. The acrylate is 2-hydroxyethyl acrylate. Bifunctional.)
(E-7) Urethane acrylate G (Polyether urethane acrylate having a weight average molecular weight of 25000. The polyol compound is tetramethylene glycol. The organic polyisocyanate compound is IPDI. The acrylate is 2-hydroxyethyl acrylate. Bifunctional.)
(E-8) Urethane methacrylate H (Polyester urethane acrylate having a weight average molecular weight of 13000. The polyol compound is a polyester polyol formed from a polycondensation product of 1,4-butane diol and ethylene diol with adipic acid. The organic polyisocyanate compound is TDI. The methacrylate is 2-hydroxyethylmethacrylate. Bifunctional.)
(E-9) Urethane acrylate I (Polycarbonate urethane acrylate having a weight average molecular weight of 15000. The polyol compound is a polycarbonate diol. The organic polyisocyanate compound is IPDI. The acrylate is 2-hydroxyethyl acrylate. Bifunctional.)
(E-10) Urethane methacrylate J (Polyether urethane acrylate having a weight average molecular weight of 5000. The polyol compound is polypropylene glycol. The organic polyisocyanate is TDI. The methacrylate is 2-hydroxypropylmethacrylate. Bifunctional.)
(E-11) Urethane acrylate K (Polyether urethane acrylate having a weight average molecular weight of 38000. The polyol compound is tetramethylene glycol. The organic polyisocyanate compound is H-XDI. The acrylate is 4-hydroxybutyl acrylate. Bifunctional.)

The following compound was selected as the antioxidant.
4-[[4,6-bis(octylthio)-1,3,5-triazin-2-yl]amino]-2,6-ditertiary butylphenol ("IRGANOX565" manufactured by BASF Co., Ltd., hereinafter abbreviated as "IRGANOX565")

### Heating mass loss rate of cured body ("1% Heating Mass Loss Temperature of Cured Body" in the tables):

The produced resin composition was sandwiched between PET films, and cured by a black light at a cumulative light amount of 5000 mJ/cm² with a wavelength of 365 nm to produce a cured body. Ten milligrams of the obtained cured body was heated from 30°C to 350°C at a heating rate of 10°C/min under a nitrogen stream using a differential thermal mass spectrometer "TG-DTA 2000 SA" manufactured by Bruker AXS Inc. The heating mass loss rate of the obtained cured body was measured. The 1 mass% heating mass loss temperature of cured body was shown. From the viewpoint of high temperature process compatibility in semiconductor fabrication, the temperature at which the heating mass reduction rate becomes 1% by mass is preferably 200°C or more.

### Tensile Shear Adhesive Strength ("Adhesive Strength" in the tables):

A silicon wafer test piece (25 mm × 75 mm × 0.725 mm thick) and a glass wafer test piece (25 mm × 75 mm × 0.7 mm thick) were used as adhereds. Two slide glasses were laminated with a resin composition prepared having an adhesion site of 25 mm × 20 mm, and cured by a black light at a cumulative light amount of 5000 mJ/cm² with a wavelength of 365 nm to produce a tensile shear adhesive strength test piece. Tensile shear adhesive strength of the produced test piece was measured in accordance with JIS K 6850 at the tensile rate of 10 mm/min at a temperature of 23°C and a humidity of 50% using a universal testing machine.

### Peeling/Disassembly Test ("Peeling Force" in the tables):

A 4-inch silicon wafer (diameter 10 mm × 0.47 mm thick) and a 4-inch glass wafer (diameter 10 mm × 0.7 mm thick) were laminated with the produced resin composition, and then cured by a black light at a cumulative light amount of 5000 mJ/cm² with a wavelength of 365 nm to produce a peeling/disassembly test piece. The resin composition was coated on the entire lamination surface. The black light was irradiated from the 4-inch glass wafer surface. A pet sheet or a blade was inserted in between the obtained test piece, and then the test piece was vacuum-held by suction on a porous chuck with dicing tape and the glass wafer side facing upward. The chuck was held by suction to the glass wafer and pulled upward, and the peeling force when detaching the glass wafer from the silicon wafer was measured. As the test piece for evaluation of the peeling force after heating, a test piece produced by vacuum-heating the adhered body at 210°C for 1 hour after irradiation with the black light was used. The peeling force after irradiation with black light (before heating) and the peeling force after heating were evaluated. A smaller peeling force indicates superior release properties.

### Tackiness ("Tackiness" in the tables):

The tackiness of the surface of the cured body of the resin composition that peeled off in the peeling/disassembly test was evaluated. Cured bodies having tackiness were evaluated as "Yes", and those without tackiness were evaluated as "No".

**[Table 1]**

| Experiment No. | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Component (A) (parts by mass) | M111 | 35 | 35 | 35 | 35 | 32 | 37 | 23 | 23 | 23 | 23 |
| | ISTA | 2 | 2 | 3 | 3 | 3 | 3 | 2 | 2 | 2 | 2 |
| | ADMA | | | | | | | | | | |
| Component (B) (parts by mass) | TMPTM | | | | | | | | | | |
| | A-DCP | 1 | 1 | | | | | | | | |
| | Pentaerythritol Tetra(meth)acrylate | 7.5 | 7.5 | 4.5 | 4.5 | 5.4 | 5.1 | 5.4 | 5.4 | 6.3 | 6.3 |
| | Dipentaerythritol Hexa(meth)acrylate | | | | | | | | | | |
| Component (C) (parts by mass) | I-651 | 1 | 1 | 1 | 1 | 1 | 1 | 1 | 1 | 1 | 1 |
| | I-379 | | | | | | | | | | |
| | 1-819 | | | | | | | | | | |
| Component (D) (parts by mass) | F-553 | | | | | | | | | | |
| | FC-4430 | 0.3 | 0.3 | 0.3 | 0.3 | 0.3 | 0.3 | 0.3 | 0.3 | 0.3 | 0.3 |
| | X-22-2516 | 0.5 | 0.5 | 0.5 | 0.5 | 0.5 | 0.5 | 0.5 | 0.5 | 0.5 | 0.5 |
| | X-22-4515 | | | | | | | | | | |
| | TSF4446 | | | | | | | | | | |
| | HC-600 | | | | | | | | | | |
| | HC-2000 | | | | | | | | | | |
| Component (E) (parts by mass) | Urethane Acrylate A | 17.5 | 17.5 | 10.5 | 10.5 | 12.6 | 11.9 | 12.6 | 12.6 | 14.7 | 14.7 |
| | Urethane Acrylate B | | | | | | | | | | |
| | Urethane Acrylate C | 37 | | 47 | | | | 57 | | 54 | |
| | Urethane Acrylate D | | 37 | | 47 | | | | 57 | | 54 |
| | Urethane Acrylate E | | | | | 47 | | | | | |
| | Urethane Acrylate F | | | | | | 43 | | | | |
| | Urethane Acrylate G | | | | | | | | | | |
| | Urethane Acrylate H | | | | | | | | | | |
| | Urethane Acrylate I | | | | | | | | | | |
| | Urethane Acrylate J | | | | | | | | | | |
| | Urethane Acrylate K | | | | | | | | | | |
| Antioxidant (parts by mass) | IRGANOX565 | | | | | | | | | | |
| Temperature of Cured Body (°C) causing 1% Heating Mass Loss | | 230 | 225 | 226 | 224 | 242 | 256 | 234 | 222 | 237 | 227 |
| Adhesive Strength (MPa) | | 0.81 | 0.79 | 0.78 | 0.76 | 0.78 | 0.81 | 0.72 | 0.71 | 0.74 | 0.73 |
| Peeling Force | Before Heating | 5.5N | 4.9N | 5.7N | 5.0N | 5.2N | 5.1N | 5.5N | 4.7N | 4.8N | 4.5N |
| | After Heating (heating for 1 hour at 210°C in vacuum) | 1.3N | <1N | 2.3N | <1N | 2.2N | <1N | <1N | <1N | <1N | <1N |
| Tackiness | | No | No | No | No | No | No | No | No | No | No |

**[Table 2]**

| Experiment No. | | Example 11 | Example 12 | Example 13 | Example 14 | Example 15 | Example 16 | Example 17 | Example 18 | Example 19 | Example 20 |
|---|---|---|---|---|---|---|---|---|---|---|---|
| Component (A) (parts by mass) | M111 | 23 | 23 | 35 | 23 | 23 | 23 | | 22 | 23 | 23 |
| | ISTA | 2 | 2 | 2 | 2 | 2 | 2 | 2 | 2 | 2 | 2 |
| | ADMA | | | | | | | 23 | | | |
| Component (B) (parts by mass) | TMPTM | | | | | | | | 1 | | |
| | A-DCP | | | 1 | | | | | | | |
| | Pentaerythritol Tetra(meth)acrylate | 7.5 | 7.5 | | 6.3 | 6.3 | 6.3 | 6.3 | 6.3 | 6.3 | 6.3 |
| | Dipentaerythritol Hexa(meth)acrylate | | | 10 | | | | | | | |
| Component (C) (parts by mass) | I-651 | 1 | 1 | 1 | 1 | 1 | 1 | | 1 | 0.4 | 1 |
| | I-379 | | | | | | | 1 | | | |
| | I-819 | | | | | | | | | 0.4 | |
| Component (D) (parts by mass) | F-553 | | | | | | | | | 0.3 | 0.3 |
| | FC-4430 | 0.3 | 0.3 | 0.3 | 0.3 | 0.3 | 0.3 | 0.3 | 0.3 | | |
| | X-22-2516 | 0.5 | 0.5 | 0.5 | | | | | | | |
| | X-22-4515 | | | | 1 | | 0.45 | 0.45 | 0.45 | 0.45 | 0.45 |
| | TSF4446 | | | | | 0.5 | 0.05 | 0.05 | 0.05 | 0.05 | 0.05 |
| | HC-600 | | | | | | | 1 | | | |
| | HC-2000 | | | | | | | | 1 | | |
| Component (E) (parts by mass) | Urethane Acrylate A | 17.5 | 17.5 | | 14.7 | 14.7 | 14.7 | 14.7 | 14.7 | 14.7 | 14.7 |
| | Urethane Acrylate B | | | 15 | | | | | | | |
| | Urethane Acrylate C | 50 | | 37 | 54 | 54 | 54 | 54 | 54 | 54 | 54 |
| | Urethane Acrylate D | | 50 | | | | | | | | |
| | Urethane Acrylate E | | | | | | | | | | |
| | Urethane Acrylate F | | | | | | | | | | |
| | Urethane Acrylate G | | | | | | | | | | |
| | Urethane Acrylate H | | | | | | | | | | |
| | Urethane Acrylate I | | | | | | | | | | |
| | Urethane Acrylate J | | | | | | | | | | |
| | Urethane Acrylate K | | | | | | | | | | |
| Antioxidant (parts by mass) | IRGANOX565 | | | | | | | | | | 1 |
| Temperature of Cured Body (°C) causing 1% Heating Mass Loss | | 240 | 230 | 232 | 233 | 240 | 241 | 232 | 242 | 242 | 236 |
| Adhesive Strength (MPa) | | 0.77 | 0.76 | 0.78 | 0.89 | 0.72 | 0.75 | 0.69 | 0.79 | 0.72 | 0.71 |
| Peeling Force | Before Heating | 4.6N | 4.4N | 5.6N | 5.5N | 4.6N | 4.9N | 5.7N | 5.1N | 5.2N | 5.5N |
| | After Heating (heating for 1 hour at 210°C in vacuum) | <1N | <1N | 2.2N | <1N | <1N | <1N | 2.1N | <1N | <1N | <1N |
| Tackiness | | No | No | No | No | No | No | No | No | No | No |

**[Table 3]**

| Experiment No. | | Example 21 | Example 22 | Example 23 | Example 24 | Example 25 |
|---|---|---|---|---|---|---|
| Component (A) (parts by mass) | M111 | 40 | 40 | 37 | 32 | 40 |
| | ISTA | 3 | 3 | 5 | 3 | 4 |
| | ADMA | | | | | |
| Component (B) (parts by mass) | TMPTM | | | | | |
| | A-DCP | | | | | |
| | Pentaerythritol Tetra(meth)acrylate | 5.4 | 5.4 | 5.4 | 5.4 | 5.4 |
| | Dipentaerythritol Hexa(meth)acrylate | | | | | |
| Component (C) (parts by mass) | I-651 | 1 | 1 | 1 | 1 | 1 |
| | I-379 | | | | | |
| | I-819 | | | | | |
| Component (D) (parts by mass) | F-553 | | | | | |
| | FC-4430 | 0.3 | 0.3 | 0.3 | 0.3 | 0.3 |
| | X-22-2516 | 0.5 | 0.5 | 0.5 | 0.5 | 0.5 |
| | X-22-4515 | | | | | |
| | TSF4446 | | | | | |
| | HC-600 | | | | | |
| | HC-2000 | | | | | |
| Component (E) (parts by mass) | Urethane Acrylate A | 12.6 | 12.6 | 12.6 | 12.6 | 12.6 |
| | Urethane Acrylate B | | | | | |
| | Urethane Acrylate C | | | | | |
| | Urethane Acrylate D | | | | | |
| | Urethane Acrylate E | | | | | |
| | Urethane Acrylate F | | | | | |
| | Urethane Acrylate G | 39 | | | | |
| | Urethane Acrylate H | | 39 | | | |
| | Urethane Acrylate I | | | 40 | | |
| | Urethane Acrylate J | | | | 47 | |
| | Urethane Acrylate K | | | | | 38 |
| Antioxidant (parts by mass) | IRGANOX565 | | | | | |
| Temperature of Cured Body (°C) causing 1% Heating Mass Loss | | 239 | 241 | 249 | 230 | 228 |
| Adhesive Strength (MPa) | | 0.85 | 0.89 | 0.88 | 0.75 | 0.83 |
| Peeling Force | Before Heating | 5.2N | 8.1N | 8.9N | 5.0N | 7.2N |
| | After Heating (heating for 1 hour at 210°C in vacuum) | 2.0N | 2.5N | 2.8N | 2.0N | 2.1N |
| Tackiness | | No | No | No | No | No |

**[Table 4]**

| Experiment No. | | Comparative Example 1 | Comparative Example 2 | Comparative Example 3 | Comparative Example 4 |
|---|---|---|---|---|---|
| Component (A) (parts by mass) | M111 | | 47 | 46 | 95 |
| | ISTA | | 3 | 3 | 5 |
| | ADMA | | | | |
| Component (B) (parts by mass) | TMPTM | | | | |
| | A-DCP | 4 | | 1 | 3 |
| | Pentaerythritol Tetra(meth)acrylate | | | | |
| | Dipentaerythritol Hexa(meth)acrylate | | | | |
| Component (C) (parts by mass) | I-651 | 1 | 1 | 1 | 1 |
| | I-379 | | | | |
| | I-819 | | | | |
| Component (D) (parts by mass) | F-553 | | | | |
| | FC-4430 | 0.3 | 0.3 | | 0.3 |
| | X-22-2516 | 0.5 | 0.5 | | 0.5 |
| | X-22-4515 | | | | |
| | TSF4446 | | | | |
| | HC-600 | | | | |
| | HC-2000 | | | | |
| Component (E) (parts by mass) | Urethane Acrylate A | | | | |
| | Urethane Acrylate B | | | | |
| | Urethane Acrylate C | 96 | 50 | 50 | |
| | Urethane Acrylate D | | | | |
| | Urethane Acrylate E | | | | |
| | Urethane Acrylate F | | | | |
| | Urethane Acrylate G | | | | |
| | Urethane Acrylate H | | | | |
| | Urethane Acrylate I | | | | |
| | Urethane Acrylate J | | | | |
| | Urethane Acrylate K | | | | |
| Antioxidant (parts by mass) | IRGANOX565 | | | | |
| Temperature of Cured Body (°C) causing 1% Heating Mass Loss | | 210 | 205 | 230 | 159 |
| Adhesive Strength (MPa) | | 0.41 | 0.43 | 0.82 | 0.21 |
| Peeling Force | Before Heating | 4N | 10N | 31N | >32N |
| | After Heating (heating for 1 hour at 210°C in vacuum) | 1.5N | 15N | >32N | >32N |
| Tackiness | | No | Yes | No | Yes |

It can be seen from Tables 1 to 4 that the resin composition according to the present invention has excellent adhesive properties, heat resistance, and release properties. When component (A) is not used, the composition does not have heat resistance. When component (B) is not used, the composition does not have heat resistance or release properties. When component (D) is not used, the composition does not have release properties. When component (E) is not used, tackiness increases and the composition does not have release properties or heat resistance (comparative examples).

The present invention has heat resistance and adhesive properties when used as a temporary fixing adhesive for semiconductor fabrication, for example.

By using component (E), the present invention reduces surface tackiness while maintaining flexibility, which enables the peeling speed to be increased without damaging the wafer, and as a result an improvement in productivity is expected.

By using the component (E), the present invention can improve the modulus of elasticity and can be peeled without the adhesive breaking away, so that as a result the adhesive residue is less likely to turn into particles and the subsequent cleaning process can be simplified. Further, since in the conventional art adhesive strength tended to increase by heating, there was a problem in that the release properties deteriorated due to the increase in the adhesive strength resulting from a heating step, such as an insulating film forming step performed before the peeling step. The resin composition according to the present invention has high adhesive properties before heating, but those adhesive properties are reduced by heating, and hence the resin composition of the present invention can be easily peeled off even after heating. Specifically, the present resin composition lessens damage and the like during wafer processing, also lessens damage to the wafer during peeling, and greatly contributes to an improvement in the quality of the product.

### [Industrial Applicability]

For example, the present invention improves release properties by using the polyfunctional urethane (meth)acrylate (E). In the present invention, by using the polyfunctional urethane (meth)acrylate (E), surface tack is small, and hence peeling time is short and productivity can be increased.

The composition according to the present invention has excellent workability and productivity in the production of various electronic parts, optical parts, and optical devices, due to its ability to easily exhibit strong adhesive properties simply by irradiating with ultraviolet light or visible light. The cured body of the present composition provides a very low outgas even at a high temperature of 200°C. Therefore, various electronic parts, optical parts, and optical devices adhered using the present composition are applicable even when subjecting to vapor deposition processing at a high temperature exceeding 200°C or baking and coating at high temperatures.

In addition to electronic parts such as ICs, resistors, and inductors, surface mounting on circuit boards is also being applied to optical parts such as image sensors. In that case, a hot solder reflow process is carried out. In recent years, particularly along with the trend towards making solder lead free, the temperature condition for solder reflow is becoming more difficult. In such a production process, in order to enhance the quality of the optical component or the optical device, or to increase productivity and the production yield, the usage site of the composition needs to be capable of sufficiently withstanding a high-temperature heat treatment. Optical parts and optical devices manufactured using the present composition can sufficiently withstand the high-temperature heat treatment, which is very useful industrially.

## Claims

1. A composition comprising the following components (A) to (E) :
component (A): a monofunctional (meth)acrylate having a number average molecular weight of less than 1000;
component (B): a polyfunctional (meth)acrylate having a number average molecular weight of less than 1000;
component (C): a radical polymerization initiator;
component (D): a releasability imparting compound that is a liquid at a temperature of 20±15°C; and
component (E): a polyfunctional urethane (meth)acrylate;
the number average molecular weight and the weight average molecular weight being measured according to the description;
**characterized in that** the component (D) is one or more selected from the group consisting of fluorine compounds and olefinic compounds.

2. The composition according to claim 1, wherein the component (E) has a weight average molecular weight of 40000 or less.

3. The composition according to claim 1 or 2, wherein
the component (E) has a content of 35 to 90 parts by mass based on a total of components (A), (B), and (E) of 100 parts by mass,
the component (D) has a content of 0.01 to 5 parts by mass based on a total of components (A), (B), and (E) of 100 parts by mass, and
the component (C) has a content of 0.1 to 4 parts by mass based on a total of components (A), (B), and (E) of 100 parts by mass.

4. The composition according to any one of claims 1 to 3, wherein the component (D) is a non-radical polymerizable compound.

5. The composition according to any one of claims 1 to 4, wherein the component (D) further comprises a silicone compound.

6. The composition according to any one of claims 1 to 5, wherein the olefinic compound of component (D) is one or more selected from the group consisting of polyethylene polymers, polypropylene polymers, and ethylene/propylene copolymers.

7. The composition according to any one of claims 1 to 6, wherein
the component (A) is one or more selected from the group consisting of phenoxypolyalkylene glycol mono(meth)acrylates having an alkylene oxide chain, alkyl (meth)acrylates having a linear or branched chain alkyl group, monofunctional (meth)acrylates having an alicyclic alkyl group, and silicones having one (meth)acryloyl group,
the component (B) is one or more selected from the group consisting of trimethylolpropane tri(meth)acrylate, ditrimethylolpropane tetra(meth)acrylate, tricyclodecane dimethanol di(meth)acrylate, dipentaerythritol hexa(meth)acrylate, pentaerythritol tetra(meth)acrylate, and pentaerythritol tri(meth)acrylate, and
the component (C) is a photo-radical polymerization initiator.

8. A resin composition for semiconductor fabrication formed from the composition according to any one of claims 1 to 7.

9. An adhesive formed from the composition according to any one of claims 1 to 7.

10. A cured body obtained by curing the composition according to any one of claims 1 to 7.

11. A temporary fixing adhesive for semiconductor fabrication formed from the composition according to any one of claims 1 to 7.

12. An adhered body in which a base material is adhered with the temporary fixing adhesive for semiconductor fabrication according to claim 11.

13. A method of fabricating a thinned wafer using the temporary fixing adhesive for semiconductor fabrication according to claim 11.

## Patentansprüche

1. Zusammensetzung, welche die folgenden Komponenten (A) bis (E) umfasst:
Komponente (A): ein monofunktionelles (Meth)acrylat mit einem zahlenmittleren Molekulargewicht von weniger als 1000;
Komponente (B): ein polyfunktionelles (Meth)acrylat mit einem zahlenmittleren Molekulargewicht von weniger als 1000;
Komponente (C): ein Initiator für eine radikalische Polymerisation;
Komponente (D): eine Ablösbarkeit vermittelnde Verbindung, die bei einer Temperatur von 20±15 °C als Flüssigkeit vorliegt; und
Komponente (E): ein polyfunktionelles Urethan(meth)acrylat;
wobei das zahlenmittlere Molekulargewicht und das gewichtsmittlere Molekulargewicht gemäß der Beschreibung gemessen werden;
**dadurch gekennzeichnet, dass** es sich bei der Komponente (D) um eine oder mehrere, ausgewählt aus der Gruppe bestehend aus Fluorverbindungen und Olefinverbindungen, handelt.

2. Zusammensetzung nach Anspruch 1, wobei die Komponente (E) ein gewichtsmittleres Molekulargewicht von 40000 oder weniger aufweist.

3. Zusammensetzung nach Anspruch 1 oder 2,
wobei die Komponente (E) einen Gehalt von 35 bis 90 Masseteilen aufweist, bezogen auf eine Gesamtmenge der Komponenten (A), (B) und (E) von 100 Masseteilen,
die Komponente (D) einen Gehalt von 0,01 bis 5 Masseteilen aufweist, bezogen auf eine Gesamtmenge der Komponenten (A), (B) und (E) von 100 Masseteilen, und
die Komponente (C) einen Gehalt von 0,1 bis 4 Masseteilen aufweist, bezogen auf eine Gesamtmenge der Komponenten (A), (B) und (E) von 100 Masseteilen.

4. Zusammensetzung nach einem der Ansprüche 1 bis 3, wobei die Komponente (D) eine nicht radikalisch polymerisierbare Verbindung ist.

5. Zusammensetzung nach einem der Ansprüche 1 bis 4, wobei die Komponente (D) ferner eine Siliconverbindung umfasst.

6. Zusammensetzung nach einem der Ansprüche 1 bis 5, wobei es sich bei der Olefinverbindung von Komponente (D) um eine oder mehrere, ausgewählt aus der Gruppe bestehend aus Polyethylenpolymeren, Polypropylenpolymeren und Ethylen/Propylen-Copolymeren, handelt.

7. Zusammensetzung nach einem der Ansprüche 1 bis 6, wobei:
es sich bei der Komponente (A) um eine oder mehrere, ausgewählt aus der Gruppe bestehend aus Phenoxypolyalkylenglykolmono(meth)acrylaten mit einer Alkylenoxidkette, Alkyl(meth)acrylaten mit einer linearen oder verzweigtkettigen Alkylgruppe, monofunktionellen (Meth)acrylaten mit einer alicyclischen Alkylgruppe und Siliconen mit einer (Meth)acryloylgruppe, handelt,
es sich bei der Komponente (B) um eine oder mehrere, ausgewählt aus der Gruppe bestehend aus Trimethylolpropantri(meth)acrylat, Ditrimethylolpropantetra(meth)acrylat, Tricyclodecandimethanoldi(meth)acrylat, Dipentaerythritolhexa(meth)acrylat, Pentaerythritoltetra(meth)acrylat und Pentaerythritoltri(meth)acrylat, handelt und
die Komponente (C) ein Photoinitiator für eine radikalische Polymerisation ist.

8. Harzzusammensetzung für die Halbleiterfertigung, die aus der Zusammensetzung nach einem der Ansprüche 1 bis 7 ausgebildet ist.

9. Klebstoff, der aus der Zusammensetzung nach einem der Ansprüche 1 bis 7 ausgebildet ist.

10. Gehärteter Körper, der durch Härten der Zusammensetzung nach einem der Ansprüche 1 bis 7 ausgebildet ist.

11. Klebstoff zur temporären Befestigung für die Halbleiterfertigung, der aus der Zusammensetzung nach einem der Ansprüche 1 bis 7 ausgebildet ist.

12. Geklebter Körper, bei dem ein Basismaterial mit dem Klebstoff zur temporären Befestigung für die Halbleiterfertigung nach Anspruch 11 geklebt ist.

13. Verfahren zur Fertigung eines gedünnten Wafers unter Verwendung des Klebstoffs zur temporären Befestigung für die Halbleiterfertigung nach Anspruch 11.

## Revendications

1. Composition comprenant les composants (A) à (E) suivants
composant (A) : un (méth)acrylate monofonctionnel ayant un poids moléculaire moyen en nombre inférieur à 1.000 ;
composant (B) : un (méth)acrylate polyfonctionnel ayant un poids moléculaire moyen en nombre inférieur à 1.000 ;
composant (C) : un initiateur de polymérisation radicalaire ;
composant (D) : un composé conférant une aptitude au décapage, étant un liquide à température de 20 ± 15 °C ;
et composant (E) : un (méth)acrylate d'uréthane polyfonctionnel ;
le poids moléculaire moyen en nombre et la masse moléculaire moyenne en poids étant mesurés conformément à la description ;
**caractérisée en ce que** le composant (D) est un ou plusieurs composés sélectionnés dans le groupe comprenant des composés fluorés et des composés oléfiniques.

2. Composition selon la revendication 1, où le composant (E) a une masse moléculaire moyenne en poids égale ou inférieure à 40.000.

3. Composition selon la revendication 1 ou la revendication 2, où le composant (E) a une teneur de 35 à 90 parties en masse sur la base d'un total de 100 parties en masse des composants (A), (B) et (E),
le composant (D) a une teneur de 0,01 à 5 parties en masse sur la base d'un total de 100 parties en masse des composants (A), (B) et (E), et
le composant (C) a une teneur de 0,1 à 4 parties en masse sur la base d'un total de 100 parties en masse des composants (A), (B) et (E).

4. Composition selon l'une des revendications 1 à 3, où le composant (D) est un composé polymérisable par polymérisation non radicalaire.

5. Composition selon l'une des revendications 1 à 4, où le composant (D) comprend en outre un composé de silicium.

6. Composition selon l'une des revendications 1 à 5, où the composé oléfinique du composant (D) est un ou plusieurs composés sélectionnés dans le groupe comprenant des polymères de polyéthylène, des polymères de polypropylène et des copolymères d'éthylène/propylène.

7. Composition selon l'une des revendications 1 à 6, où
le composant (A) est un ou plusieurs composés sélectionnés dans le groupe comprenant des mono(méth)acrylates de phénoxypolyalkylèneglycol présentant une chaîne d'oxyde d'alkylène, des (méth)acrylates d'alkyle présentant un groupe alkyle linéaire ou ramifié, des (méth)acrylates monofonctionnels ayant un groupe alkyle alicyclique, et des siliciums ayant un groupe (méth)acryloyle,
le composant (B) est un ou plusieurs composés sélectionnés dans le groupe comprenant tri(méth)acrylate de triméthylolpropane, tétra(méth)acrylate de ditriméthylolpropane, di(méth)acrylate de tricyclodécane diméthanol, hexa(méth)acrylate de dipentaérythritol, tetra(méth)acrylate de pentaérythritol, et tri(méth)acrylate de pentaérythritol, et
le composant (C) est un initiateur de polymérisation photoradicalaire.

8. Composition de résine pour la fabrication de semiconducteurs, formée à partir de la composition selon l'une des revendications 1 à 7.

9. Adhésif formé à partir de la composition selon l'une des revendications 1 à 7.

10. Corps durci obtenu par durcissement de la composition selon l'une des revendications 1 à 7.

11. Adhésif de fixation temporaire pour la fabrication de semiconducteurs, formé à partir de la composition selon l'une des revendications 1 à 7.

12. Corps collé, où un matériau de base est collé à l'adhésif de fixation temporaire pour la fabrication de semiconducteurs selon la revendication 11.

13. Procédé de fabrication d'une tranche amincie au moyen de l'adhésif de fixation temporaire pour la fabrication de semiconducteurs selon la revendication 11.
